# EUROPÄISCHE PATENTANMELDUNG

(11) **EP 0 755 103 A1**
(43) Veröffentlichungstag der Anmeldung: **22.01.1997**
(21) Anmeldenummer: 96110936.0
(22) Anmeldetag: 06.07.1996
(51) Int. Cl.: H01S 3/085, H01L 33/00

(54) **Verfahren zur Herstellung eines Lasermoduls**

(30) Priorität: 15.07.1995 DE 19525814
(71) Anmelder: ROBERT BOSCH GMBH, 70442 Stuttgart (DE)
(72) Erfinder: Storm, Hartwig, 71549 Auenwald (DE); Schmitt, Reinhold, Dr.rer.nat. Dipl.-Phys., 71546 Auenwald (DE); Hirth, Helmut, Dr.rer.nat., 71522 Backnang (DE); Panzlaff, Konrad, Dr.Ing., 71522 Backnang (DE)

(57) **Zusammenfassung**

Es wird ein Verfahren zur Herstellung eines Lasermoduls mit einem oberflächenemittierenden Laserelement (VCSE-Laser) angegeben. Auf einem Träger (1) wird einer der vom VCSE-Laser benötigten Spiegel (9) hergestellt. Das Lasermedium, sowie der zweite vom VCSE-Laser benötigte Spiegel (13) werden erst dann über dem ersten Spiegel (9) angebracht, wenn dieser erste Spiegel mit dem Träger (1) verbunden ist. Als Vorteil dieses Verfahrens wird eine erleichterte Justierung des VCSE-Lasers relativ zum Träger (1) angesehen, sowie die Herstellbarkeit eines Lasermoduls mit verbesserten optischen und elektrischen Eigenschaften.

## Beschreibung

### Stand der Technik

Die Erfindung geht aus von einem Verfahren zur Herstellung eines Lasermoduls nach der Gattung des unabhängigen Anspruchs.

Aus dem Artikel 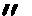 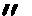 Room-Temperature Continuous-Wave Operation of 1.54-µm Vertical-Cavity lasers" in den IEEE Photonics Technology Letters, **7**, 1275 (November 1995) ist schon ein Verfahren zur Herstellung eines VCSE-Lasers für ein Lasermodul bekannt. Hierbei wird ein VCSE-Laser (Vertical Cavity Surface Emitting Laser) aus einem aktiven Halbleiterelement, in welcher die Lichtverstärkung durch stimulierte Emission stattfindet, und zwei spiegeln, welche auf der Ober- und der Unterseite des aktiven Halbleiterelements angebracht sind, hergestellt. Dieser VCSE-Laser wird auf ein bereits mikrostrukturiertes Siliziumsubstrat aufgebracht, wobei unter Umständen besondere Vorkehrungen für die Justierung des VCSE-Lasers getroffen werden müssen. Als Mikrostrukturierung ist beispielhaft eine Nut im Siliziumsubstrat, welche mit dielektrischem Material aufgefüllt wurde genannt, so daß eine Wellenleiterstruktur entsteht.

### Vorteile der Erfindung

Das erfindungsgemäße Verfahren mit den kennzeichnenden Merkmalen der unabhängigen Ansprüche hat demgegenüber den Vorteil, daß der Justieraufwand beim Ankoppeln VCSE-Lasers an andere optische Elemente, wie beispielsweise die Wellenleiterstruktur, deutlich verringert wird. Hierdurch lassen sich beträchtliche Kosteneinsparungen erzielen.

Durch die in den abhängigen Ansprüchen aufgeführten Maßnahmen sind vorteilhafte Weiterführungen und Verbesserungen der in den unabhängigen Ansprüchen angegebenen Verfahren möglich.

Es bietet sich an, die im Verfahren vorkommenden Fügeschritte mittels Waferbonding vorzunehmen, da mit diesem Verfahren eine preisgünstige Verbindungstechnik zur Verfügung steht. Darüber hinaus ist diese Technik für alle Fügeschritte im Verfahren nutzbar, so daß der apparative Aufwand zur Herstellung des Lasermoduls möglichst gering gehalten wird. Darüber hinaus erlaubt die Waferbonding-Technik das Anbringen von hochwertigen Spiegelschichten auf dem Substrat, welche in dieser Form nicht direkt aufbringbar wären.

Weiterhin ist es besonders vorteilhaft, das aktive Halbleiterelement über dem ersten Spiegel mittels metallischer elektrischer Kontakte anzubringen, da hierdurch den elektrischen Kontakten eine Dreifachfunktion als Befestigung, elektrischer Kontakt und auch Wärmeableiter zugeordnet wird, welche andernfalls mit getrennten konstruktiven Mitteln erfüllt werden müssen.

Weiterhin ist es vorteilhaft, eine Vielschichtstruktur als Spiegel für den VCSE-Laser zu benutzen, da solche Vielschichtstrukturen bei einer bestimmten Wellenlänge eine höhere Reflektanz aufweisen können als metallische Spiegelflächen.

Solche Vielfachschichten lassen sich mit relativ geringem apparatischen Aufwand mittels Aufdampfen herstellen.

Werden die spiegelnden Vielschichtstrukturen aus Halbleitermaterialien hergestellt, ist, vor allem bei kristallinem Material, eine hinreichende elektrische und thermische Leitfähigkeit realisierbar, so daß die Spiegelschichten gleichzeitig auch zum Wärmeabtransport und zum elektrischen Anschluß für den VCSE-Laser herangezogen werden können. Dies ist vorteilhaft, da somit mehrere Prozeßschritte in der Herstellung des Lasermoduls eingespart werden können.

Schließlich ist es vorteilhaft, diejenige der beiden Flächen des VCSE-Lasers, aus welcher kein Licht emittiert werden soll, mit einer metallischen Schicht zu versehen, da somit der VCSE-Laser eine gleichmäßigere Temperatur über das ganze Bauteil besitzt. Somit ergeben sich bessere elektrische und optische Eigenschaften und schließlich ein höherwertigeres Lasermodul.

### Zeichnung

Ausführungsbeispiele der Erfindung sind in der Zeichnung dargestellt und in der nachfolgenden Beschreibung näher erläutert. Es zeigen
- Figur 1: ein Lasermodul,
- Figuren 2a bis 2f: ein erstes Verfahren zur Herstellung eines Lasermoduls,
- Figuren 3a bis 3e: ein zweites Verfahren zur Herstellung eines Lasermoduls.

### Beschreibung

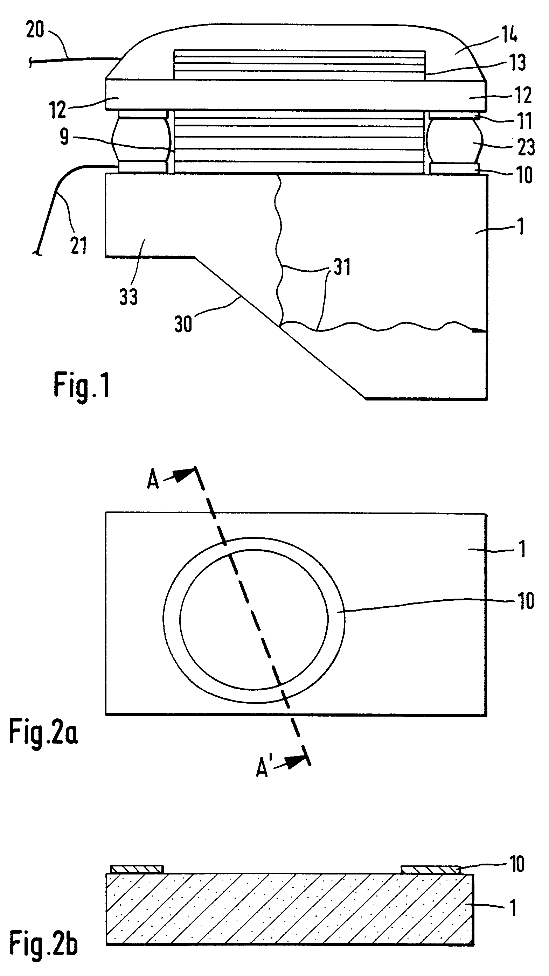

Ein Lasermodul, wie es durch das im folgenden geschilderte Verfahren hergestellt werden kann, ist in Figur 1 gezeigt. Das oberflächenemittierende Sendeelement befindet sich auf einem Träger 1. Dieser Träger ist im hier gewählten Ausführungsbeispiel ein Siliziumsubstrat, welches eine Mikrostrukturierung für optische Elemente aufweist. Im hier gewählten Ausführungsbeispiel weist das Substrat auf seiner Unterseite eine schräge Stufe 30 auf. Auf der Oberseite des Trägers 1, etwa über der schrägen Stufe 30, befindet sich eine erste Vielschichtstruktur 9, welche beispielsweise aus einer Abfolge von jeweils drei Siliziumoxid- und drei Siliziumschichten besteht. Auf dieser ersten Vielschichtstruktur 9 befindet sich das aktive Halbleiterelement 12, welches als Lasermedium des VCSE-Lasers dient. Im vorliegenden Beispiel hat das aktive Halbleiterelement 12 die Gestalt eines flachen Plättchens, dessen Durchmesser etwas größer ist als derjenige der ersten Vielschichtstruktur 9, auf welcher sich das aktive Halbleiterelement 12 befindet. Auf dem aktiven Halbleiterelement 12 befindet sich eine zweite Vielschichtstruktur 13, welche den gleichen Durchmesser wie die erste Vielschichtstruktur 9 aufweist, und beispielsweise aus jeweils zwei Silizium- und Siliziumdioxidschichten besteht. Die zweite Vielschichtstruktur 13 sowie der Teil des aktiven Halbleiterelements 12, welcher nicht von der zweiten Vielschichtstruktur 13 bedeckt wird, ist mit einer Isothermalisierungsschicht 14 aus Gold bedeckt. Auf seiner Unterseite trägt das aktive Halbleiterelement 12 eine in etwa ringförmige flache Metallisierungsschicht. Diese Metallisierungsschicht wird als oberes Kontaktpad 11 benutzt. Eine ebenso geformte zweite Metallisierungsschicht befindet sich auf der Oberseite des Trägers 1, so angeordnet daß sie möglichst genau unter dem oberen Kontaktpad 11 lokalisiert ist. Diese zweite Metallisierungsschicht wird als unteres Kontaktpad 10 benutzt. Zwischen dem oberen Kontaktpad 11 und dem unteren Kontaktpad 12 befindet sich eine Lotschicht 23, welche die Verbindung zwischen dem oberen Kontaktpad 11 und dem unteren Kontaktpad 12 herstellt. Die Isothermalisierungsschicht 14 ist mit einer ersten Zuleitung 20 verbunden, das untere Kontaktpad ist mit einer zweiten Zuleitung 21 verbunden. Aus dem von der ersten Vielschichtstruktur 9, dem aktiven Laserelement 12 und der zweiten Vielschichtstruktur 13 gebildeten VCSE-Laser tritt durch die erste Vielschichtstruktur 9 Laserlicht 31 aus, welches sich zuerst in etwa senkrecht zur Oberfläche des Substrats 33 fortpflanzt, bis es auf die schräge Stufe 30 trifft, wo es reflektiert wird und sich dann in etwa parallel zur Oberfläche des Substrats 33 im Substrat 33 fortpflanzt.

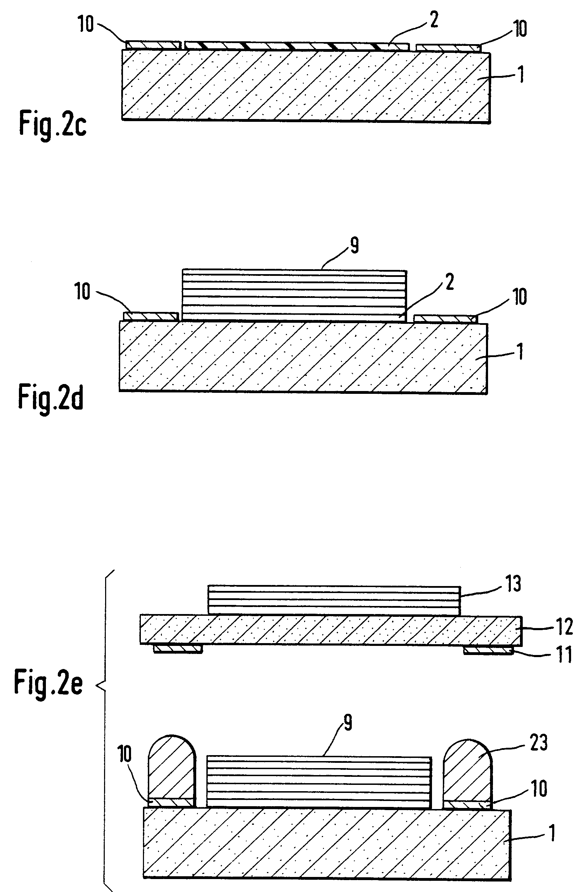

Das Verfahren zur Herstellung des Lasermoduls soll anhand der Figuren 2a bis 2f näher beschrieben werden. Ein Träger 1 ist in der Aufsicht in Figur 2a gezeigt. Dieser Träger 1 ist wiederum ein Siliziumsubstrat, welches eine Mikrostrukturierung aufweisen kann, die aber in Figur 2a nicht gezeigt ist. Auf der Oberfläche des Trägers 1 befindet sich das untere Kontaktpad 10, welches die Form einer ringförmigen Metaliisierungsschicht aufweist. Weiterhin zeigt Figur 2a eine gestrichelte Linie AA', welche die Schnittlinie für die in den nachfolgenden Figuren dargestellten Schnittzeichnungen darstellt.

Der Träger 1 mit dem unteren Kontaktpad 10 ist nochmals in Figur 2b als Schnittzeichnung dargestellt. Es ist vorgesehen, daß der Träger 1 zu diesem Zeitpunkt schon mikrostrukturiert ist, jedoch werden die Mikrostrukturen, der übersichtlicheren Darstellung wegen, in Figuren 2a bis 2f nicht dargestellt.

Auf dem Träger 1 wird nun auf die vom unteren Kontaktpad begrenzte Fläche eine Vielfachschichtstruktur aufgebracht. Im hier gezeigten Ausführungsbeispiel geschieht dies durch wechselweises Aufdampfen von Siliziumoxid- und Siliziumschichten. In Figur 2c ist der Träger 1 gezeigt, nachdem eine erste dielektrische Schicht 2 aus Siliziumoxid aufgedampft wurde.

Zum in Figur 2d dargestellten Zeitpunkt ist die erste Vielschichtstruktur 9 komplettiert. Sie besteht aus jeweils drei Siliziumoxid- und Siliziumschichten, welche nacheinander aufgedampft wurden. Sie bilden zusammen die erste Vielschichtstruktur 9.

In einem parallel laufenden Fertigungsprozeß wird ein aktives Halbleiterelement 12 in Form eines Plättchens auf der Unterseite mit einem oberen Kontaktpad in Form einer ringförmigen Metallisierungsschicht versehen, sowie mit einer zweiten Vielschichtstruktur 13 auf der anderen Oberfläche. Im hier gezeigten Ausführungsbeispiel besteht die zweite Vielschichtstruktur 13 aus je zwei Siliziumoxid und Siliziumschichten, welche abwechselnd auf das aktive Halbleiterelement 12 aufgedampft wurden. Das mit der zweiten Vielschichtstruktur 13 und dem oberen Kontaktpad 11 versehene aktive Halbleiterelement 12 wird nun in die Nähe des mit dem unteren Kontaktpad 10 und der ersten Vielschichtstruktur 9 versehenen Trägers 1 gebracht, dergestalt, daß die mit den Kontaktpads 10, 11 versehenen Flächen sich etwa gegenüber liegen. Auf eines der beiden Kontaktpads, im hier gezeigten Ausführungsbeispiel auf das untere Kontaktpad 10, wird eine Lotschicht 23 aufgebracht.

In diesem Zustand sind die beiden noch getrennten Teile des Lasermoduls in Figur 2e gezeigt.

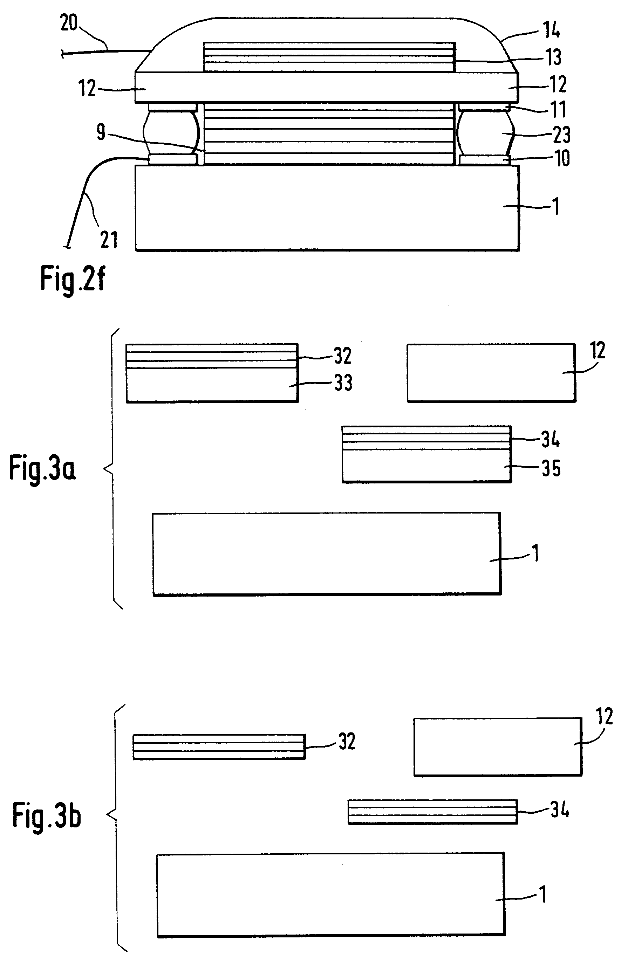

Das aktive Halbleiterelement 12 und der Träger 1 werden nun zusammengefügt, so daß das Lot 23 die beiden Teile über die oberen Kontaktpads 11 und die unteren Kontaktpads 10 miteinander verbindet. Nach dem Fügeschritt wird eine Goldschicht auf die Oberseite des Bauteils aufgedampft, welche die vom Substrat abgewandte Fläche des aktiven Halbleiterelements 12 sowie die zweite Vielschichtstruktur 13 bedeckt und eine Isothermalisierungsschicht 14 bildet. Die Isolthermalisierungsschicht 14 wird mit einer ersten Zuleitung 20 verbunden, sowie das untere Kontaktpad 10 mit einer zweiten Zuleitung 21. Das hiermit erhaltene Lasermodul ist in Figur 2f dargestellt.

Das von den beiden Vielschichtstrukturen 9 und 13 abgegrenzte Halbleiterelement 12 funktioniert nun als VCSE-Laser. Bei Anlegen einer Spannung über die Zuleitungen 20 und 21 an das aktive Halbleiterelement 12 wird Licht erzeugt. Die Vielschichtstrukturen 9 und 13 reflektieren dieses Licht zurück in das aktive Halbleiterelement 12, so daß die zum Laserbetrieb notwendige stimulierte Emission stattfindet. Im geschilderten Ausführungsbeispiel sind die Vielschichtstrukturen durch Aufdampfen von dielektrischen Materialien entstanden. Durch den Aufdampfprozeß entstehen keine einkristallinen Schichten. Die Benutzung anderer Materialien für die Vielschichtstrukturen ist jedoch ebenso vorgesehen wie die Benutzung von amorphen, mikrokristallinen oder auch einkristallinen dünnen Schichten. Bei der Kombination der verschiedenen Schichten ist es wichtig, vorzusehen, daß die Vielschichtstruktur eine hohe Reflektanz im geplanten Frequenzbereich des VCSE-Lasers aufweist. Gleichzeitig sollte die Vielschichtstruktur möglichst geringe Absorption im selben Frequenzbereich aufweisen sowie eine geringe, aber von null verschiedene Transmission, so daß ein Teil des Laserlichts in den Träger 1 abgestrahlt wird. Die als Isothermalisierungsschicht 14 aufgebrachte Goldschicht dient dazu, ein in etwa lateral homogenes Temperaturprofil über das aktive Halbleiterelement 12 herzustellen. Dies ist sinnvoll, da hierdurch bessere elektrische und optische Eigenschaften im VCSE-Laser erreicht werden. Gleichzeitig kann die Isothermalisierungsschicht 14 auch zur weiteren elektrischen Kontaktierung des aktiven Halbleiterelements 12 herangezogen werden. In Abwandlung des oben geschilderten Ausführungsbeispiels ist es auch vorgesehen, die Isothermalisierungsschicht 14 unmittelbar nach Aufbringen der zweiten Vielschichtstruktur 13 auf das aktive Halbleiterelement 12 aufzubringen, bevor das aktive Halbleiterelement 12 mit dem Träger 1 und der darauf befindlichen ersten Vielschichtstruktur 9 verbunden wird. Ebenso ist auch die Verwendung anderer thermisch gut leitender Materialien für die Isothermalisierungsschicht 14 vorgesehen. Die Kontaktpads 10 und 11 erfüllen im oben gezeigten Ausführungsbeispiel eine Dreifachfunktion. Zusammen mit der Lotschicht 23 fixieren sie das aktive Halbleiterelement 12 auf der ersten Vielschichtstruktur 9. Weiterhin erlauben sie eine elektrische Kontaktierung des aktiven Halbleiterelements 12. Schließlich ermöglichen sie eine verbesserte Wärmeabfuhr aus dem aktiven Halbleit-erelement 12. Zur besten Wärmeabfuhr ist es sinnvoll, diese elektrische Kontaktierung mit möglichst großem Querschnitt auszuführen, insbesondere als Ringstruktur um die erste Vielschichtstruktur 9 herum. Durch die bessere Wärmeabfuhr erreicht man sowohl eine höhere Lebensdauer des VCSE-Lasers als auch verbesserte optische und elektrische Eigenschaften des Lasermoduls. Andere Ausführungen der Kontaktpads, beispielsweise in Form von zwei Halbkreisen, so daß Zwei Kontaktierungen über den Träger möglich werden, sind ebenfalls möglich und vorgesehen.

Die Position der ersten Vielschichtstruktur, welche als Spiegel für den VCSE-Laser dient, bestimmt die Justierung des Lasers. Das Anbringen dieser Vielschichtstruktur 9 auf dem Träger 1 erlaubt somit eine genaue Justierung des VCSE-Lasers relativ zu anderen Mikrostrukturen, wie beispielsweise der schrägen Stufen 30 im Träger 1. Durch die getrennte Fertigung und das getrennte Zusammenfügen von aktivem Halbleiterelement 12 und zweiter Vielschichtstruktur 13 lassen sich sämtliche Vorteile nutzen, welche dadurch erreicht werden, daß der VCSE-Laser und der Träger getrennt gebaut werden, und erst im letzten Schritt zusammengefügt werden, wie beispielsweise einfachere Prozeßführung, leichter optimierbare Materialien, billigere Fertigung, ohne beim Zusammenfügen von VCSE-Laser und Träger auf eine aufwendige aktive Justierung zurückgreifen zu müssen.

Ein zweites Ausführungsbeispiel soll anhand der Figuren 3a bis 3e erläutert werden. In vorbereitenden Prozeßschritten werden vier Bauteile erzeugt: Ein Träger 1, in welchem Mikrostrukturen vorgesehen sein können, welche in Figur 3a nicht gezeigt sind, ein aktives Halbleiterelement 12, sowie eine erste Vielschichtstruktur 32 auf einem ersten Hilfssubstrat 33 und eine zweite Vielschichtstruktur 34 auf einem Hilfssubstrat 35. Die erste Vielschichtstruktur 32 wird beispielsweise durch epitaktisches Wachstum von verschiedenen Halbleiterschichten auf dem ersten Hilfssubstrat, welches beispielsweise ein einkristallines Halbleitersubstrat ist, erreicht. Diese vier Bestandteile sind in Figur 3a abgebildet.

Nach erfolgtem Wachstum der epitaktischen Halbleiterschichten für die erste Vielschichtstruktur 32 und die zweite Vielschichtstruktur 34 werden die Hilfssubstrate 33 und 35 entfernt. Dies kann beispielsweise durch Ätzen geschehen. Durch diesen Schritt wird eine freistehende erste Vielschichtstruktur 32 und eine freistehende zweite Vielschichtstruktur 34 erhalten. Diese beiden Bauteile werden zusammen mit den in diesem Schritt unveränderten Träger 1 und dem aktiven Halbleiterelement 12 in Figur 3b gezeigt.

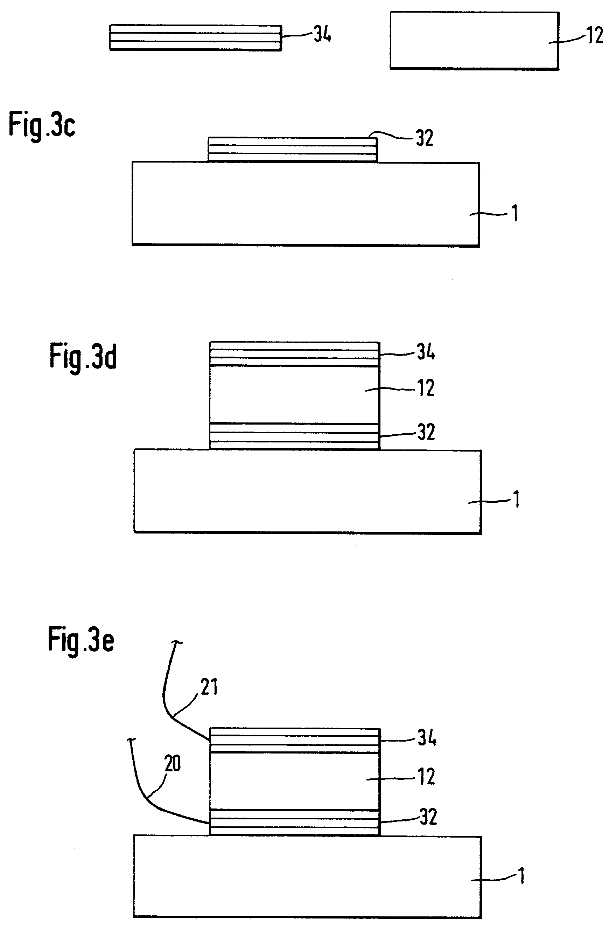

Die erste Vielschichtstruktur 32 wird nun auf dem Träger 1 in die gewünschte Position gebracht und mittels Waferbonding mit dem Träger 1 zu einem Bauteil verbunden. Die resultierenden drei Bauteile sind in Figur 3c dargestellt.

In gleicher Weise wird als nächstes das aktive Halbleiterelement 12 auf die erst Vielschichtstruktur 32 aufgelegt und mittels Waferbonding verbunden. Schließlich wird die zweite Vielschichtstruktur 34 auf das aktive Halbleiterelement 12 aufgebracht und ebenso durch Waferbonding verbunden. Die resultierende Struktur ist in Figur 3d dargestellt.

Die erste Vielschichtstruktur 32 wird mit einer ersten Zuleitung 20 versehen, ebenso wird die zweite Vielschichtstruktur 34 mit einer zweiten Zuleitung 21 versehen. Hierdurch ergibt sich ein Lasermodul wie es in Figur 3e dargestellt ist.

Durch die beim epitaktischen Wachstum erzielbare hohe kristallographische Qualität sowie durch die Verwendung halbleitenden Materialien anstelle von isolierenden Materialien werden in diesem Ausführungsbeispiel Spiegel erhalten, welche hinreichend elektrisch und thermisch leitfähig sind. Somit können diese Spiegel die Kontaktpads 10 und 11 sowie die Isothermalisierungsschicht 14 ersetzen.

Ebenso wird durch den Einsatz von einkristallinen halbleitenden Materialien für die Spiegel dies Verbindungstechnik des Waferbonding einsetzbar, womit sich ein einfacher Herstellungsprozeß ergibt, da eine Verbindungstechnik für alle Verbindungsschritte eingesetzt wird. Es wird somit auch möglich, alle vier Bauelemente wie sie in Figur 3b gezeigt sind aufeinander zu legen und in einem einzigen Fügeschritt zu verbinden. Unter Waferbonding wird die feste Zusammenfügung zweier einkristalliner Schichten verstanden, welche auf Ausbildung von van-der-Waals-Kräften zwischen diesen basiert. Klebstoffe, Lot und dergleichen entfallen dadurch.

Es ist auch vorgesehen, in Abwandlung des zweiten Ausführungsbeispiels das erste Hilfssubstrat 33 mit der ersten Vielschichtstruktur 32 auf den Träger 1 zu positionieren, dergestalt, daß die erste Vielschichtstruktur 32 sich zwischen dem ersten Hilfssubstrat 33 und dem Träger 1 befindet. Die beiden Teile werden mittels Waferbonding verbunden. Erst nach diesem Fügeschritt wird das erste Hilfssubstrat 33 entfernt, beispielsweise durch Ätzen oder Schleifen, so daß sich die in Figur 3c dargestellte Struktur ergibt. In gleicher Weise kann auch mit der zweiten Vielschichtstruktur 34 und dem zweiten Hilfssubstrat 35 verfahren werden. Die Handhabung der empfindlichen Vielschichtstrukturen 32 und 34 wird somit merklich erleichtert, jedoch entfällt die Möglichkeit, alle vier Bauteile in einem einzigen Waferbondingschritt zusammenzufügen.

Durch die Kombination von erstem und zweitem Ausführungsbeispiel ergeben sich weitere Ausführungsmöglichkeiten, beispielsweise das Aufdampfen einer dielektrischen Vielschichtstruktur auf das aktive Halbleiterelement 12, welches dann mit der ersten Vielschichtstruktur und dem Träger mittels Waferbonding verbunden wird.

## Patentansprüche

1. Verfahren zur Herstellung eines Lasermoduls mit einem Träger (1) und mit einem oberflächenemittierenden Sendeelement, wobei das Sendeelement einen ersten Spiegel, einen zweiten Spiegel und ein aktives Halbleiterelement (12) aufweist, mit folgenden Verfahrensschritten:
a) auf dem Träger (1) wird der erste Spiegel hergestellt,
b) das aktive Halbleiterelement (12) wird über dem ersten Spiegel auf dem Träger (1) befestigt und
c) der zweite Spiegel wird auf das aktive Halbleiterelement (12) aufgebracht.

2. Verfahren zur Herstellung eines Lasermoduls mit einem Träger (1) und mit einem oberflächenemittierenden Sendeelement, wobei das Sendeelement einen ersten Spiegel, einen zweiten Spiegel und ein aktives Halbleiterelement (12) aufweist, mit folgenden Verfahrensschritten:
a) auf dem Träger (1) wird der erste Spiegel hergestellt,
b) das aktive Halbleiterelement (12) wird mit dem zweiten Spiegel verbunden und
c) das mit dem zweiten Spiegel versehene aktive Halbleiterelement (12) wird mit der dem zweiten Spiegel abgewandten Fläche über dem ersten Spiegel auf dem Träger (1) befestigt.

3. Verfahren zur Herstellung eines Lasermoduls nach einem der Ansprüche 1 oder 2, dadurch gekennzeichnet, daß ein vorgefertigter Spiegel mittels Waferbonding auf dem Träger befestigt wird.

4. Verfahren zur Herstellung eines Lasermoduls nach einem der Ansprüche 1 bis 3, dadurch gekennzeichnet, daß mindestens eine der Verbindungen zwischen einem Spiegel und dem aktiven Halbleiterelement mittels Waferbonding vorgenommen wird.

5. Verfahren zur Herstellung eines Lasermoduls nach einem der vorhergehenden Ansprüche, dadurch gekennzeichnet, daß die Befestigung des aktiven Halbleiterelements (12) über dem ersten Spiegel mittels metallischer elektrischer Kontakte vorgenommen wird.

6. Verfahren zur Herstellung eines Lasermoduls nach einem der vorhergehenden Ansprüche, dadurch gekennzeichnet, daß wenigstens einer der Spiegel als eine Vielschichtstruktur (9,13) hergestellt wird.

7. Verfahren zur Herstellung eines Lasermoduls nach Anspruch 5, dadurch gekennzeichnet, daß die einzelnen Schichten des Spiegels aufgedampft werden.

8. Verfahren zur Herstellung eines Lasermoduls nach einem der Ansprüche 6 oder 7, dadurch gekennzeichnet, daß mindestens eine der Schichten in der Vielschichtstruktur (9,13), welche den Spiegel bildet, von einer Halbleiterschicht gebildet wird.

9. Verfahren zur Herstellung eines Lasermoduls nach einem der vorhergehenden Ansprüche, dadurch gekennzeichnet, daß über dem aktiven Halbleiterelement (12) und dem zweiten Spiegel eine als Isothermalisierungsschicht (14) ausgebildete weitere Schicht aufgebracht wird, die zur elektrischen Kontaktierung und zur Wärmeverteilung dient.
